# EUROPEAN PATENT APPLICATION

(11) **EP 4 852 294 A1**
(43) Date of publication of application: **09.12.2026**
(21) Application number: 25878723.3
(22) Date of filing: 14.07.2025
(51) Int. Cl.: H02M 7/44, H02M 1/00, H02S 40/32, H05K 7/20

(54) **PHOTOVOLTAIC INVERTER**

(30) Priority: 15.10.2024 CN 202411441575
(71) Applicant: Huawei Digital Power Technologies Co., Ltd., Shenzhen, Guangdong 518043 (CN)
(72) Inventor: HU, Tianqi, Shenzhen, Guangdong 518043 (CN); SHI, Hui, Shenzhen, Guangdong 518043 (CN); CHANG, Guozhu, Shenzhen, Guangdong 518043 (CN); YE, Yong, Shenzhen, Guangdong 518043 (CN); HAN, Lang, Shenzhen, Guangdong 518043 (CN)
(74) Representative: Maiwald GmbH
(86) International application number: PCT/CN2025/108423
(87) International publication number: WO 2026/081580

(57) **Abstract**

This application provides a photovoltaic inverter. The photovoltaic inverter includes a housing, and a circuit board and a power conversion circuit that are located in the housing. The housing includes a first accommodation cavity, a second accommodation cavity, a third accommodation cavity, and a fourth accommodation cavity. The power conversion circuit includes a first inductor, a bus capacitor, and a second inductor that are sequentially connected in series. The bus capacitor is located in the third accommodation cavity. The first inductor and the second inductor are located in the fourth accommodation cavity. A direct current input terminal and an alternating current output terminal are disposed on a terminal panel of the housing. The direct current input terminal extends into the first accommodation cavity and is electrically connected to the first inductor, and the alternating current output terminal extends into the second accommodation cavity and is electrically connected to the second inductor. When the photovoltaic inverter operates, a current sequentially flows through the direct current input terminal, the first inductor, the bus capacitor, the second inductor, and the alternating current output terminal, such that the current forms an approximately C-shaped flow path in the housing, thereby reducing electromagnetic interference between modules, and improving electromagnetic compatibility and operating efficiency of the photovoltaic inverter having an inverted structure.

## Description

### CROSS-REFERENCE TO RELATED APPLICATIONS

This application claims priority to Chinese Patent Application No. 202411441575.7, filed with the China National Intellectual Property Administration on October 15, 2024 and entitled "PHOTOVOLTAIC INVERTER", which is incorporated herein by reference in its entirety.

### TECHNICAL FIELD

This application relates to the field of electronic technologies, and in particular, to a photovoltaic inverter.

### BACKGROUND

A power converter may convert one type of current into another type of current, and is widely used in power supply systems and power generation systems. The power converter includes a housing, a circuit board located in the housing, and a switch component and a plurality of power components that are mounted on the circuit board.

The power converter needs to comply with an electromagnetic compatibility (electromagnetic compatibility, EMC) standard before being put into use in the market. As the switching frequency of the power converter increases and output power of the power converter becomes higher, electromagnetic susceptibility (electromagnetic susceptibility, EMS) of the power converter to another electronic device decreases, and electromagnetic signals generated by the power converter also cause greater electromagnetic interference to components inside the power converter, that is, electromagnetic interference (electromagnetic interference, EMI) of the power converter increases. Therefore, as the power of the power converter increases and an EMC requirement becomes higher, how to improve the EMC of the power converter of the foregoing structure and improve operating efficiency of the power converter becomes an important research issue.

### SUMMARY

This application provides a photovoltaic inverter, to improve electromagnetic compatibility of the photovoltaic inverter of an inverted circuit structure.

According to a first aspect, this application provides a photovoltaic inverter. The photovoltaic inverter includes a housing, a circuit board, and a power conversion circuit, where the circuit board and the power conversion circuit are accommodated in the housing. Specifically, the housing includes a bottom housing and a cover body, and the cover body is configured to cover the bottom housing. A plurality of heat dissipation fins are disposed on a surface of a side of the bottom housing that faces away from the cover body. The circuit board is disposed between the bottom housing and the cover body, and a plane on which the circuit board is located is parallel to a surface of the cover body relative to the bottom housing. A plurality of spacer plates are disposed on the bottom housing, and the plurality of spacer plates extend from the bottom housing toward the circuit board, and divide space between the bottom housing and the circuit board into a plurality of accommodation cavities. The plurality of accommodation cavities include a first accommodation cavity, a second accommodation cavity, a third accommodation cavity, and a fourth accommodation cavity. The bottom housing or the cover body includes a terminal panel, and the terminal panel includes a direct current input terminal and an alternating current output terminal. The first accommodation cavity, the second accommodation cavity, and the third accommodation cavity are all disposed adjacent to the terminal panel. The third accommodation cavity is located between the first accommodation cavity and the second accommodation cavity, the fourth accommodation cavity is located on a side of the third accommodation cavity that faces away from the terminal panel, and the third accommodation cavity is located between the fourth accommodation cavity and the first accommodation cavity, or the third accommodation cavity is located between the fourth accommodation cavity and the second accommodation cavity. The power conversion circuit includes a first inductor, a bus capacitor, and a second inductor that are sequentially connected in series. The bus capacitor is located in the third accommodation cavity. The first inductor and the second inductor are located in the fourth accommodation cavity. The direct current input terminal penetrates the terminal panel, one end of the direct current input terminal that extends into the first accommodation cavity is electrically connected to the first inductor, and the other end of the direct current input terminal is configured to be electrically connected to a photovoltaic module. The alternating current output terminal penetrates the terminal panel, one end of the alternating current output terminal that extends into the second accommodation cavity is electrically connected to the second inductor, and the other end of the alternating current output terminal is configured to be electrically connected to a power grid or a load. The power conversion circuit further includes a power module, the power module is located in the third accommodation cavity, and an insulating and thermally conductive substrate is disposed between the power module and a bottom wall of the third accommodation cavity.

In this embodiment of this application, the photovoltaic inverter uses an inverted structure, to simplify a cable design of the power conversion circuit. Compared with a manner in which the power conversion circuit is disposed in the housing in a forward direction (a manner in which the first inductor, the bus capacitor, and the second inductor are disposed between the circuit board and the cover body), in the inverted structure, a distance between a heat emitting component and the bottom housing is shorter, that is, a heat transfer distance required by the heat emitting component is shorter, and the heat dissipation fin may directly transfer, from the bottom housing to the heat dissipation fin, heat generated by the heat emitting component, and dissipate heat. This helps accelerate heat dissipation inside the photovoltaic inverter. When the photovoltaic inverter operates, a current enters from the direct current input terminal, sequentially passes through the first inductor, the bus capacitor, and the second inductor, and flows out of the alternating current output terminal. To be specific, the current sequentially flows along the first accommodation cavity, the third accommodation cavity, the fourth accommodation cavity, the third accommodation cavity, the fourth accommodation cavity, the third accommodation cavity, and the second accommodation cavity, to form an approximately C-shaped current path in the housing. This can reduce current path crossing, and reduce impedance of the power conversion circuit. In addition, the plurality of components are placed in the separated accommodation cavities, so that electromagnetic interference between the components can be reduced. This improves electromagnetic compatibility of the photovoltaic inverter, reduces a loss of the photovoltaic inverter, and improves operating efficiency of the photovoltaic inverter.

Because a volume of the bus capacitor is large, to improve space utilization of the housing, in a possible implementation, in the third accommodation cavity, a groove is disposed on a surface of a side of the bottom housing that faces the cover body, and the bus capacitor is partially accommodated in the groove. In this way, a surface shape of the side of the bottom housing that faces the cover body is the same as a surface shape of a side of the power conversion circuit that faces the bottom housing, so that a thermally conductive path between the bottom housing and each module of the photovoltaic inverter is uniform, and a volume of the photovoltaic inverter is smaller than that of a photovoltaic inverter whose bottom housing is a flat plate.

An insulating film is disposed in the groove, an explosion-relief valve is disposed on a surface of a side of the bus capacitor that faces the insulating film, and the explosion-relief valve is spaced from the insulating film by a predetermined distance. When the explosion-relief valve is opened, a valve cover of the explosion-relief valve pops out and abuts against the insulating film. The insulating film can keep the bottom housing insulated from the bus capacitor, to avoid a short circuit between the bus capacitor and another component via the bottom housing when the bus capacitor is faulty.

In addition, when the bus capacitor is faulty, electrolyte inside the bus capacitor may be sprayed out of the bus capacitor. In a possible implementation, the plurality of spacer plates include a first spacer plate, and the first accommodation cavity and the third accommodation cavity are separated by the first spacer plate. In the third accommodation cavity, a guide plate is disposed on the side of the bottom housing that faces the cover body, and a plane on which the guide plate is located is perpendicular to the surface of the cover body relative to the bottom housing. The guide plate is located between the groove and the terminal panel, one end of the guide plate is connected to the first spacer plate, and the other end of the guide plate inclines toward the terminal panel, so that the guide plate guides the electrolyte in the groove, to prevent the electrolyte from flowing into another accommodation cavity and damaging another component.

In a possible implementation, the power conversion circuit further includes a first communication circuit, the first communication circuit is accommodated in the third accommodation cavity and is disposed close to the terminal panel. The terminal panel further includes a first communication terminal. The first communication terminal penetrates the terminal panel, and one end of the first communication terminal that extends into the third accommodation cavity is electrically connected to the first communication circuit. The first communication terminal is configured to transmit data in parallel to an external device, and the other end of the guide plate inclines toward the first communication terminal. In this technical solution, because the first communication circuit is a circuit with weak power, the guide plate guides the electrolyte in the groove toward the first communication terminal, to prevent the electrolyte from entering a circuit with strong power and causing damage to the power conversion circuit.

In a possible implementation, the plurality of spacer plates may further include a second spacer plate, and the second spacer plate divides the fourth accommodation cavity into a first cavity and a second cavity. The first cavity and the second cavity are separately disposed adjacent to the third accommodation cavity. The first inductor is accommodated in the first cavity, and the second inductor is accommodated in the second cavity. In the fourth accommodation cavity, the second spacer plate separates the first inductor from the second inductor, so that interference between the first inductor and the second inductor can be reduced. In addition, the second spacer plate may further increase a heat dissipation area between the first inductor and the housing and a heat dissipation area between the second inductor and the housing, to improve heat dissipation efficiency of the first inductor and the second inductor.

In a possible implementation, the power module includes a first switching transistor and a second switching transistor. The first switching transistor is electrically connected between the direct current input terminal and the first inductor, and the second switching transistor is electrically connected between the bus capacitor and the second inductor. The first switching transistor is disposed close to the first inductor, and the second switching transistor is disposed close to the second inductor. The first switching transistor may be configured to conduct or disconnect an electrical connection between the first inductor and the direct current input terminal, and the second switching transistor may be configured to conduct or disconnect an electrical connection between the second inductor and the bus capacitor. The switching transistor and the inductor are separated, so that interference between the switching transistor and the inductor can be reduced, and a heat dissipation area between the power module and the bottom housing is increased.

In a possible implementation, the power conversion circuit further includes a plurality of relays, and the plurality of relays are located between the circuit board and the bottom housing. The plurality of spacer plates include a third spacer plate, and the second accommodation cavity and the third accommodation cavity are separated by the third spacer plate. A thermal pad is disposed at an end of the third spacer plate that faces the cover body, and the thermal pad is configured to be in contact with the circuit board. The plurality of relays are distributed in two rows on two sides of the thermal pad. When the photovoltaic inverter operates, the relay and a region of the circuit board that is close to the relay generate heat. The thermal pad may be attached to the circuit board, so that the heat near the relay on the circuit board is transferred to the bottom housing via the thermal pad, thereby further reducing heat of the relay.

In a possible implementation, a metal support is further disposed at the end of the third spacer plate that faces the cover body. The thermal pad is fastened to an end of the metal support that faces the cover body, and the plurality of relays are distributed in two rows on two sides of the metal support. Therefore, the metal support may be configured to accommodate the relay, and may also transfer heat of the thermal pad to the bottom housing.

In a possible implementation, the plurality of accommodation cavities further include a fifth accommodation cavity, the fifth accommodation cavity is disposed adjacent to the terminal panel, and the fifth accommodation cavity is located between the third accommodation cavity and the second accommodation cavity. The power conversion circuit further includes a second communication circuit, and the second communication circuit is accommodated in the fifth accommodation cavity, and is configured to send and receive interaction data. The terminal panel further includes a second communication terminal. The second communication terminal penetrates the terminal panel, and one end of the second communication terminal that extends into the fifth accommodation cavity is electrically connected to the second communication circuit. The second communication terminal is configured to transmit data serially to the external device. In this technical solution, the second communication terminal, the direct current input terminal, and the alternating current output terminal are disposed on a same side, so that wiring of the photovoltaic inverter can be disposed on a same side, to facilitate mounting of the photovoltaic inverter.

In a possible implementation, the photovoltaic inverter further includes a switch, the switch is disposed in the housing, and the switch is connected between the direct current input terminal and the first inductor. The switch is configured to conduct or disconnect an electrical connection between the photovoltaic module and the power conversion circuit, so that when a fault occurs, an output direct current of the photovoltaic module and the direct current input circuit of the photovoltaic inverter can be disconnected, to protect the photovoltaic inverter.

In a possible implementation, a chip resistor, a chip capacitor, and a signal indicator are disposed on a side of the circuit board that faces the cover body. The signal indicator is configured to indicate an operating status of the photovoltaic inverter. In the inverted structure, a space height between the circuit board and the cover body is small, and small-volume components may be disposed, to fully use space in the housing.

### BRIEF DESCRIPTION OF DRAWINGS

FIG. 1 is a diagram of an application scenario of a photovoltaic system according to an embodiment of this application;
FIG. 2 is a front view of a photovoltaic inverter according to an embodiment of this application;
FIG. 3 is a rear view of a photovoltaic inverter according to an embodiment of this application;
FIG. 4 is an exploded view of a photovoltaic inverter according to an embodiment of this application;
FIG. 5 is a diagram of a bottom housing according to an embodiment of this application;
FIG. 6 is a diagram of a power conversion circuit and a bottom housing according to an embodiment of this application;
FIG. 7 is a diagram of a current path of a photovoltaic inverter during operation according to an embodiment of this application;
FIG. 8 is a diagram of a power conversion circuit according to an embodiment of this application;
FIG. 9 is another diagram of a bottom housing according to an embodiment of this application;
FIG. 10 is another diagram of a power conversion circuit and a bottom housing according to an embodiment of this application;
FIG. 11 is still another diagram of a bottom housing according to an embodiment of this application;
FIG. 12 is a cross-sectional view of the bottom housing in FIG. 11 taken along an A-A direction;
FIG. 13 is a cross-sectional view of a photovoltaic inverter taken along the A-A direction in FIG. 11 according to an embodiment of this application;
FIG. 14 is yet another diagram of a bottom housing according to an embodiment of this application;
FIG. 15 is a sectional view of the bottom housing in FIG. 14 in a B-B direction;
FIG. 16 is still another diagram of a power conversion circuit and a bottom housing according to an embodiment of this application;
FIG. 17 is still yet another diagram of a bottom housing according to an embodiment of this application;
FIG. 18 is another diagram of a power conversion circuit according to an embodiment of this application;
FIG. 19 is a further diagram of a bottom housing according to an embodiment of this application;
FIG. 20 is a diagram of a thermal pad and a metal support according to an embodiment of this application; and
FIG. 21 is a still further diagram of a bottom housing according to an embodiment of this application.

### Reference numerals:

10: photovoltaic system;
11: photovoltaic module;
12: photovoltaic inverter;
13: energy storage device;
20: power grid;
31: first accommodation cavity;
32: second accommodation cavity;
33: third accommodation cavity;
34: fourth accommodation cavity;
35: fifth accommodation cavity;
121: housing;
122: power conversion circuit;
123: switch;
331: groove;
332: guide plate;
333: insulating film;
334: thermal pad;
335: metal support;
336: first insulating and thermally conductive substrate;
337: second insulating and thermally conductive substrate;
341: second spacer plate;
342: first cavity;
343: second cavity;
1210: terminal panel;
1211: cover body;
1212: bottom housing;
1213: direct current input terminal;
1214: alternating current output terminal;
1215: spacer plate;
1216: heat dissipation fin;
1217: first communication terminal;
1218: second communication terminal;
1221: direct current input circuit;
1222: direct current conversion circuit;
1223: bus capacitor;
1224: inverter circuit;
1225: alternating current output circuit;
1226: circuit board;
1227: filter circuit;
1228: first communication circuit;
1229: second communication circuit;
12151: first spacer plate;
12152: third spacer plate;
12221: first inductor;
12222: first switching transistor;
12241: second inductor;
12242: second switching transistor;
12271: relay;
12261: chip resistor;
12262: chip capacitor; and
12263: signal indicator.

### DESCRIPTION OF EMBODIMENTS

To make objectives, technical solutions, and advantages of this application clearer, the following further describes this application in detail with reference to accompanying drawings.

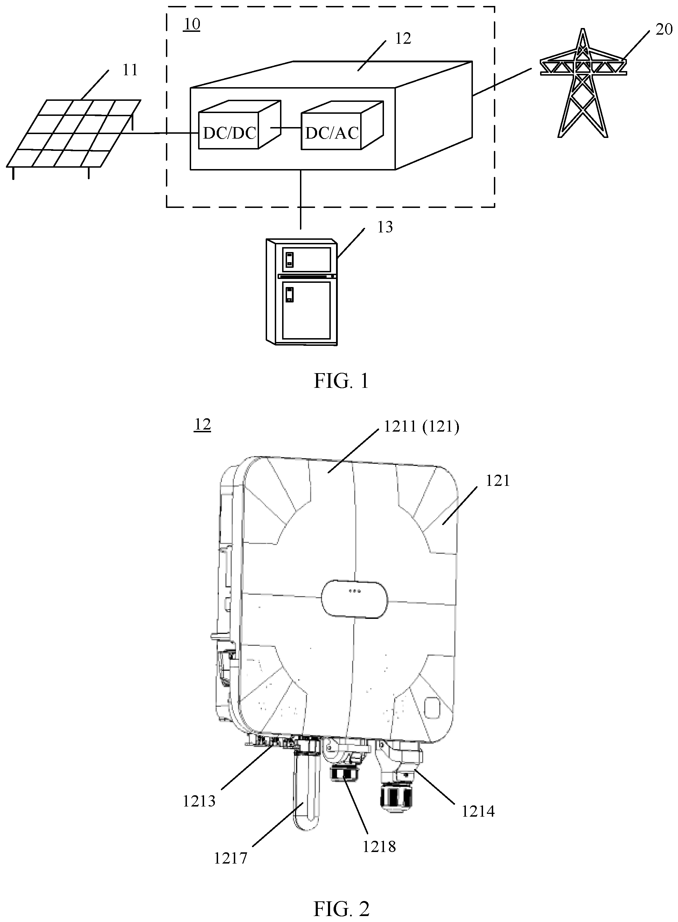

To facilitate understanding of a photovoltaic inverter provided in embodiments of this application, the following describes an application scenario of the photovoltaic inverter. The photovoltaic inverter in this application may be used in a power supply system and a power generation system. A photovoltaic system is used as an example. The photovoltaic system may be used in two application scenarios: a home power plant and an industrial photovoltaic power plant. The photovoltaic inverter can convert solar energy into electric energy for a power grid or a load. FIG. 1 is a diagram of an application scenario of a photovoltaic system according to an embodiment of this application. As shown in FIG. 1, the photovoltaic system 10 is used in a home power plant. Specifically, a photovoltaic module 11 is configured to convert light energy into electric energy. The photovoltaic system 10 includes a photovoltaic inverter 12. One end of the photovoltaic inverter 12 is configured to connect to the photovoltaic module 11, and the other end is configured to connect to a power grid 20. The photovoltaic inverter 12 is configured to: convert a direct current from the photovoltaic module 11 into an alternating current, and transmit the alternating current to the power grid 20. A photovoltaic optimizer may be further mounted in the photovoltaic system 10, and the photovoltaic optimizer may be configured to improve power generation efficiency of the photovoltaic module 11. The photovoltaic optimizer is a module-level power electronic device with a direct current input and a direct current output, is connected to the photovoltaic module 11 in series, uses a predictive current and voltage technology to ensure that the module is always in an optimal operating state, and according to an operating principle of a buck topology, is configured to resolve impact of shadow shading, inconsistent directions, or different module electrical specifications on an energy yield of a photovoltaic power plant, so as to implement a maximum power output of the photovoltaic module 11 and improve the energy yield of the photovoltaic system 10. Certainly, the photovoltaic system 10 may further include an energy storage device 13. The alternating current converted by the photovoltaic inverter 12 may be further transmitted to the energy storage device 13 for energy storage.

In addition, an on/off-grid controller may be further disposed between the photovoltaic inverter 12 and the power grid 20. The photovoltaic inverter 12 may convert the direct current provided by the photovoltaic module 11 into the alternating current, and transfer the alternating current to the on/off-grid controller. The on/off-grid controller may further be electrically connected to a power-consuming device. In an actual application scenario, the on/off-grid controller has an off-grid state and an on-grid state. When the on/off-grid controller is in the off-grid state, the on/off-grid controller is not electrically connected to the power grid 20, and the alternating current transmitted by the photovoltaic inverter 12 is provided only to the power-consuming device. The power-consuming device includes a household appliance, for example, includes a television, an air conditioner, a refrigerator, and a washing machine.

When the on/off-grid controller is in the on-grid state, the on/off-grid controller is electrically connected to the power grid 20 via a power sensor. When the electric energy generated by the photovoltaic module 11 cannot meet a power consumption requirement of the power-consuming device, the power grid 20 may supply electric energy to the photovoltaic system 10 via the on/off-grid controller. When the energy yield of the photovoltaic module 11 exceeds an amount of electric energy used by the power-consuming device, the on/off-grid controller may transfer surplus electric energy to the power grid 20. The power sensor is configured to measure a power flow status between the photovoltaic system 10 and the power grid 20. For example, the power sensor may be an electricity meter.

As a loss requirement and an efficiency requirement of the photovoltaic system increase, an electromagnetic compatibility requirement of the photovoltaic inverter also gradually increases. Therefore, how to improve electromagnetic compatibility of the photovoltaic inverter gradually becomes a key problem to be researched.

In view of this, this application provides a photovoltaic inverter, to improve electromagnetic compatibility of the photovoltaic inverter of an inverted circuit structure.

It should be noted that terms used in the following embodiments are merely intended to describe specific embodiments, but are not intended to limit this application. Terms "one", "a", "the", "the foregoing", "this" and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "contain", "have", and their variants all mean "include but are not limited to", unless otherwise specifically emphasized in another manner.

Terms "first", "second", and the like in this application are merely for a purpose of description, and shall not be construed as indicating or implying relative importance or implicitly indicating a quantity of indicated technical features. Therefore, a feature limited by "first" or "second" may explicitly or implicitly include one or more features. In the descriptions of this application, unless otherwise stated, "a plurality of" means two or more.

In addition, in this specification, orientation terms such as "top", "bottom", "up", and "down" are defined relative to orientations of structures schematically placed in the accompanying drawings. It should be understood that these orientation terms are relative concepts used for relative description and clarification, and may correspondingly change based on changes in the orientations in which the structure are placed.

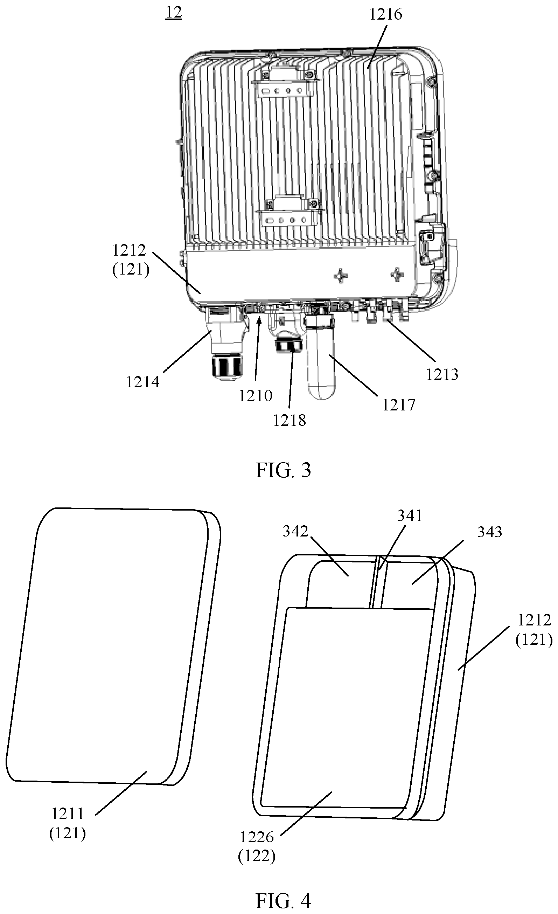

FIG. 2 is a front view of a photovoltaic inverter according to an embodiment of this application. FIG. 3 is a rear view of the photovoltaic inverter according to an embodiment of this application. FIG. 4 is an exploded view of the photovoltaic inverter according to an embodiment of this application. As shown in FIG. 2 to FIG. 4, the photovoltaic inverter 12 includes a housing 121 and a power conversion circuit 122. The housing 121 includes a cover body 1211 and a bottom housing 1212. The cover body 1211 is configured to: cover the bottom housing 1212, and form an internal space for accommodating the power conversion circuit 122. In actual application, a surface of a side (namely, a rear side) of the bottom housing 1212 that faces away from the cover body 1211 is mounted on a mounting plate, and the cover body 1211 (namely, a front side) faces a user.

It should be noted that, in some embodiments, the bottom housing 1212 may be of a basin-shaped structure. To be specific, the bottom housing 1212 includes a bottom housing bottom plate and a plurality of bottom housing side plates, and the plurality of bottom housing side plates are sequentially connected and are perpendicular to the bottom housing bottom plate. In this embodiment, the cover body 1211 may be of a plate-shaped structure, and is disposed opposite to the bottom housing bottom plate. An outer periphery of the cover body 1211 is connected to the plurality of bottom housing side plates, thereby forming a space for accommodating the power conversion circuit 122. Certainly, in this embodiment, the cover body 1211 may alternatively be of the basin-shaped structure. To be specific, the cover body 1211 includes a cover body bottom plate and a plurality of cover body side plates, and the plurality of cover body side plates are sequentially connected and are perpendicular to the cover body bottom plate. The cover body bottom plate and the bottom housing bottom plate are disposed opposite to each other, and the plurality of cover body side plates are connected to the plurality of bottom housing side plates, thereby forming a space for accommodating the power conversion circuit 122. In some other embodiments, the cover body 1211 may be of the basin-shaped structure. The bottom housing 1212 may be of the plate-shaped structure, and is disposed opposite to the cover body bottom plate. The bottom housing 1212 is connected to the plurality of cover body side plates, thereby forming a space for accommodating the power conversion circuit 122.

The following describes in detail a structure of the photovoltaic inverter 12 by using an example of the housing 121 whose bottom housing 1212 may be of the basin-shaped structure and cover body 1211 may be of the plate-shaped structure.

The photovoltaic inverter in this application uses an inverted structure, to simplify a cable design of the power conversion circuit and implement centralized heat dissipation of heat emitting components. As shown in FIG. 4, the photovoltaic inverter 12 further includes a circuit board 1226. A plane on which the circuit board 1226 is located is parallel to a surface of the cover body 1211 relative to the bottom housing 1212. Specifically, a front side of the circuit board 1226 is disposed toward the cover body 1211, and a switch component and a plurality of power components of the power conversion circuit 122 are located on a rear side of the circuit board 1226 and are disposed toward the bottom housing bottom plate of the bottom housing 1212. In this way, the switch component and the plurality of power components may be connected to the circuit board 1226 via pins, to implement a rigid connection to the circuit board 1226, thereby simplifying the cable design.

As shown in FIG. 3, in the housing 121 in this application, a plurality of heat dissipation fins 1216 are disposed on a surface of a side of the bottom housing 1212 that faces away from the cover body 1211. Compared with a manner in which the power conversion circuit 122 is disposed in the housing 121 in a forward direction (a manner in which a first inductor 12221, a bus capacitor 1223, and a second inductor 12241 are disposed on a side of the circuit board 1226 that faces the cover body 1211), in the foregoing embodiment, the inverted structure may shorten a distance between the heat emitting component and the bottom housing 1212, that is, a heat transfer distance required by the heat emitting component is shorter, and the heat dissipation fin 1216 may directly transfer, from the bottom housing 1212 to the heat dissipation fin 1216, heat generated by the heat emitting component, and dissipate heat. This helps accelerate heat dissipation inside the photovoltaic inverter 12.

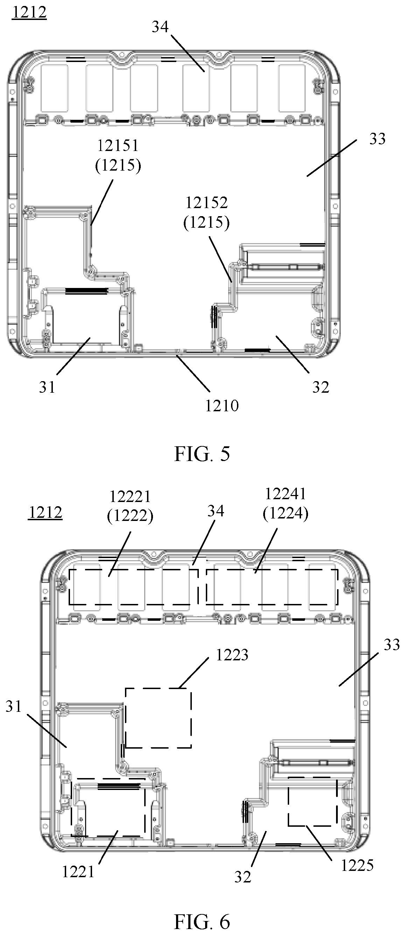

FIG. 5 is a diagram of the bottom housing according to an embodiment of this application. As shown in FIG. 5, a plurality of spacer plates 1215 are disposed on the bottom housing 1212, and the spacer plates 1215 extend from the bottom housing 1212 toward the circuit board 1226, and divide space between the bottom housing 1212 and the circuit board 1226 into a plurality of accommodation cavities. These accommodation cavities are separated from each other. The plurality of accommodation cavities include a first accommodation cavity 31, a second accommodation cavity 32, a third accommodation cavity 33, and a fourth accommodation cavity 34. The housing 121 includes a terminal panel 1210. The terminal panel 1210 may be a part of the bottom housing 1212, or may be a part of the cover body 1211. As shown in FIG. 2 and FIG. 3, the terminal panel 1210 is a bottom housing side plate of the bottom housing 1212. The terminal panel 1210 includes a direct current input terminal 1213 and an alternating current output terminal 1214. In this embodiment, the first accommodation cavity 31, the second accommodation cavity 32, and the third accommodation cavity 33 are all disposed adjacent to the terminal panel 1210. In other words, the terminal panel 1210 may form side walls of the first accommodation cavity 31, the second accommodation cavity 32, and the third accommodation cavity 33. The third accommodation cavity 33 is located between the first accommodation cavity 31 and the second accommodation cavity 32, the fourth accommodation cavity 34 is located on a side of the third accommodation cavity 33 that faces away from the terminal panel 1210, and the third accommodation cavity 33 is located between the fourth accommodation cavity 34 and the first accommodation cavity 31, or the third accommodation cavity 33 is located between the fourth accommodation cavity 34 and the second accommodation cavity 32.

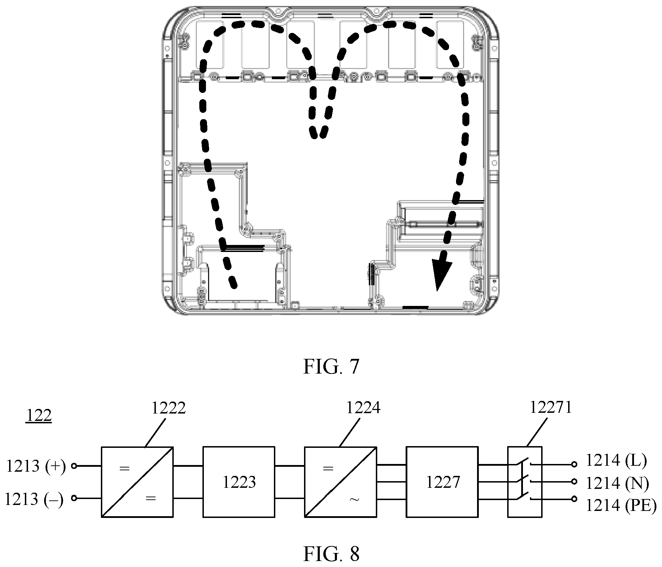

FIG. 6 is a diagram of the power conversion circuit and the bottom housing according to an embodiment of this application. FIG. 7 is a diagram of a current path of the photovoltaic inverter during operation according to an embodiment of this application. As shown in FIG. 6 and FIG. 7, in this embodiment of this application, the power conversion circuit 122 includes the first inductor 12221, the bus capacitor 1223, and the second inductor 12241 that are sequentially connected in series. The bus capacitor 1223 is located in the third accommodation cavity 33. The first inductor 12221 and the second inductor 12241 are located in the fourth accommodation cavity 34. The direct current input terminal 1213 penetrates the terminal panel 1210, one end of the direct current input terminal 1213 that extends into the first accommodation cavity 31 is electrically connected to the first inductor 12221, and the other end of the direct current input terminal 1213 is configured to be electrically connected to a photovoltaic module 11. The alternating current output terminal 1214 penetrates the terminal panel 1210, one end of the alternating current output terminal 1214 that extends into the second accommodation cavity 32 is electrically connected to the second inductor 12241, and the other end of the alternating current output terminal 1214 is electrically connected to a power grid 20 or a load.

When the photovoltaic inverter 12 operates, a current sequentially passes through the direct current input terminal 1213, the first inductor 12221, the bus capacitor 1223, the second inductor 12241, and the alternating current output terminal 1214, so that the current sequentially flows along the first accommodation cavity 31, the third accommodation cavity 33, the fourth accommodation cavity 34, the third accommodation cavity 33, the fourth accommodation cavity 34, the third accommodation cavity 33, and the second accommodation cavity 32, to form an approximately C-shaped current path in the housing 121. This can reduce current path crossing, and reduce impedance of the power conversion circuit 122. In addition, the plurality of components are placed in different accommodation cavities that are separated, so that electromagnetic interference between the components can be reduced. This improves electromagnetic compatibility of the photovoltaic inverter 12, reduces a loss of the photovoltaic inverter 12, and improves operating efficiency of the photovoltaic inverter 12. In this way, a loss of a photovoltaic system 10 is reduced and operating efficiency is improved.

FIG. 8 is a diagram of the power conversion circuit according to an embodiment of this application. As shown in FIG. 8, in the photovoltaic inverter 12, the power conversion circuit 122 includes a direct current conversion circuit 1222, the bus capacitor 1223, and an inverter circuit 1224. The direct current conversion circuit 1222 includes the first inductor 12221, and the inverter circuit 1224 includes the second inductor 12241. Further, the power conversion circuit 122 further includes a filter circuit 1227 and a relay 12271. The filter circuit 1227 is connected between the inverter circuit 1224 and the alternating current output terminal 1214, the relay 12271 is connected between the filter circuit 1227 and the alternating current output terminal 1214, and the relay 12271 may be used as an output protection switch, to ensure stability of an output current. In addition, the power conversion circuit 122 may further include a direct current input circuit 1221 and an alternating current output circuit 1225. The direct current input circuit 1221 is connected between the direct current input terminal 1213 and the direct current conversion circuit 1222, the direct current input circuit 1221 is accommodated in the first accommodation cavity 31, and the direct current input circuit 1221 is connected to the direct current input terminal 1213. The alternating current output circuit 1225 is connected between the relay 12271 and the alternating current output terminal 1214, and the alternating current output circuit 1225 is accommodated in the second accommodation cavity 32.

In addition, the power conversion circuit 122 further includes a power module, and the power module is located in the third accommodation cavity 33. An insulating and thermally conductive substrate is disposed between the power module and a bottom wall of the third accommodation cavity 33. The power module is thermally connected to the bottom housing 1212 via the insulating and thermally conductive substrate, so that heat dissipation efficiency of the power module can be accelerated. In addition, when the bus capacitor 1223 is faulty, the insulating and thermally conductive substrate may prevent the bottom housing 1212 from being in a short-circuited connection to the power module when the bus capacitor 1223 is in a short-circuited connection to the bottom housing 1212.

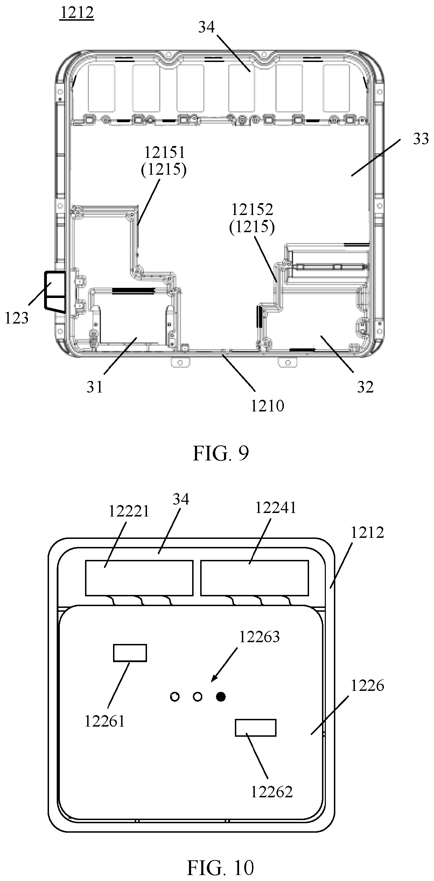

FIG. 9 is another diagram of the bottom housing according to an embodiment of this application. As shown in FIG. 9, the photovoltaic inverter 12 further includes a switch 123. The switch 123 is connected to the direct current input circuit 1221, and is configured to conduct or disconnect the direct current input circuit 1221. In this way, when the photovoltaic system 10 is faulty, an electrical connection between the photovoltaic module 11 and the direct current input circuit 1221 may be disconnected via the switch 123, to disconnect a direct current output current between the direct current input circuit 1221 and the photovoltaic module 11, so as to protect the photovoltaic inverter 12.

In the inverted structure described above, a space height between the circuit board 1226 and the cover body 1211 is small, and small-volume components may be disposed, to fully use space in the housing 121. FIG. 10 is another diagram of the power conversion circuit and the bottom housing according to an embodiment of this application. As shown in FIG. 10, in an embodiment, a chip resistor 12261, a chip capacitor 12262, and a signal indicator 12263 are disposed on a side of the circuit board 1226 that faces the cover body 1211. The chip resistor 12261 may be configured to limit a current in the circuit, resist interference and noise of the circuit, and the like. The chip capacitor 12262 may be configured to store an electric charge. The signal indicator 12263 is configured to indicate an operating status of the photovoltaic inverter 12, for example, a normal operating state, a standby state, or a communication connection state. In this embodiment, a quantity of signal indicators 12263 is not limited. For example, in an embodiment, one signal indicator 12263 may be disposed, and the signal indicator 12263 displays different colors to indicate statuses of the photovoltaic inverter 12. Alternatively, in another embodiment, a plurality of signal indicators 12263 may be disposed, each signal indicator 12263 displays one color, and the plurality of signal indicators 12263 have different colors. In this way, each signal indicator 12263 may fixedly indicate one status of the photovoltaic inverter 12.

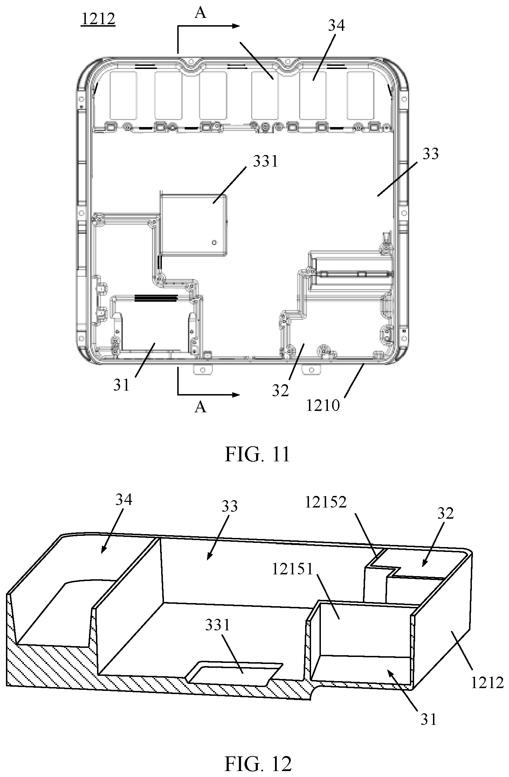

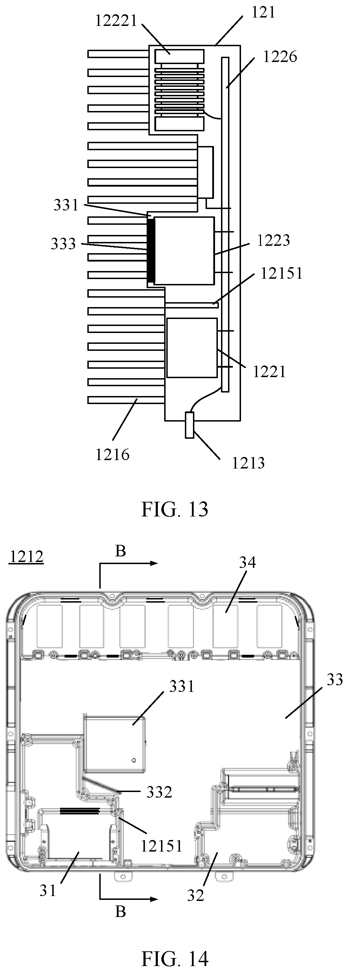

FIG. 11 is still another diagram of the bottom housing according to an embodiment of this application. FIG. 12 is a cross-sectional view of the bottom housing in FIG. 1 taken along an A-A direction. FIG. 13 is a cross-sectional view of the photovoltaic inverter taken along the A-A direction in FIG. 11 according to an embodiment of this application. As shown in FIG. 11, FIG. 12, and FIG. 13, because the bus capacitor 1223 has a large volume, to improve space utilization in the housing 121, in an embodiment, in the third accommodation cavity 33, a groove 331 is disposed on a surface of a side of the bottom housing 1212 that faces the cover body 1211, and the bus capacitor 1223 is partially accommodated in the groove 331. In this way, a surface shape of the side of the bottom housing 1212 that faces the cover body 1211 is the same as a surface shape of a side of the power conversion circuit 122 that faces the bottom housing 1212, that is, the surface shape of the side of the bottom housing 1212 that faces the cover body 1211 may be designed to fit a position of a circuit component on the circuit board 1226, so that a gap between the bottom housing 1212 and each module of the power conversion circuit 122 is uniform, and a volume of the photovoltaic inverter 12 is smaller than that of a photovoltaic inverter whose bottom housing is a flat plate. In addition, the structure design may further reduce a volume of the photovoltaic inverter 12, and increase a heat dissipation area of the circuit component.

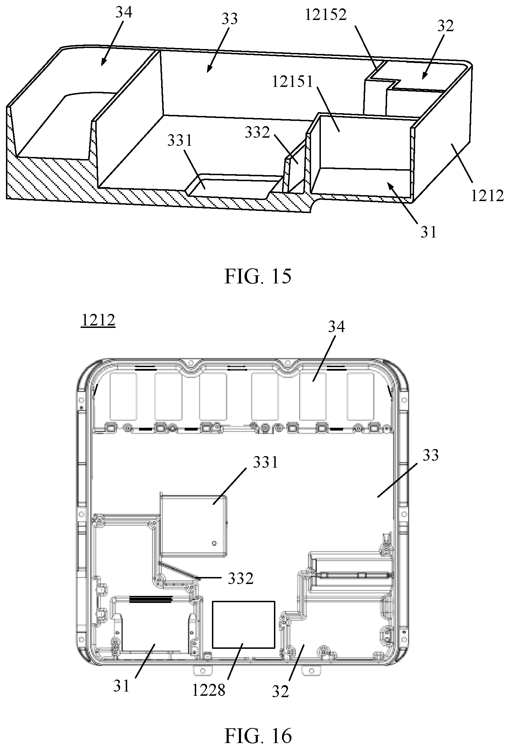

In addition, when the bus capacitor 1223 is faulty, electrolyte inside the bus capacitor 1223 may be sprayed out of the bus capacitor 1223. FIG. 14 is yet another diagram of the bottom housing according to an embodiment of this application. FIG. 15 is a sectional view of the bottom housing in FIG. 14 in a B-B direction. As shown in FIG. 14 and FIG. 15, in an embodiment, the plurality of spacer plates 1215 include a first spacer plate 12151, and the first accommodation cavity 31 and the third accommodation cavity 33 are separated by the first spacer plate 12151, that is, the first accommodation cavity 31 and the third accommodation cavity 33 are located on two sides of the first spacer plate 12151. In the third accommodation cavity 33, a guide plate 332 is disposed on the surface of the side of the bottom housing 1212 that faces the cover body 1211, and a plane on which the guide plate 332 is located is perpendicular to the surface of the cover body 1211 relative to the bottom housing 1212. The guide plate 332 is located between the groove 331 and the terminal panel 1210. One end of the guide plate 332 is connected to the first spacer plate 12151, and the other end extends toward a second side of the housing 122. In actual application, the first spacer plate 12151 cannot be completely attached to the circuit board 1226. Therefore, when the guide plate 332 is not disposed, the electrolyte in the groove 331 flows to the first spacer plate 12151 under gravity, and flows into the first accommodation cavity 31 through a gap between the first spacer plate 12151 and the circuit board 1226. Because the direct current input circuit 1221 in the first accommodation cavity 31 is a component with strong power, the circuit with strong power is short-circuited when the electrolyte flows into the first accommodation cavity 31, and results in a high safety risk. As shown in FIG. 14, the guide plate 332 guides the electrolyte in the groove 331 to a position on a side of the third accommodation cavity 33 that is close to the second side, to prevent the electrolyte from entering the first accommodation cavity 31 and damaging an electronic component of the direct current input circuit 1221.

As shown in FIG. 13, an insulating film 333 may be disposed in the groove 331. An explosion-relief valve is disposed on a surface of a side of the bus capacitor 1223 that faces the insulating film 333. The explosion-relief valve is spaced from the insulating film 333 by a predetermined distance. When the explosion-relief valve is opened, a valve cover of the explosion-relief valve pops out and abuts against the insulating film 333. The insulating film 333 can keep the bottom housing 1212 insulated from the bus capacitor 1223, to avoid a short circuit between the bus capacitor 1223 and another component via the bottom housing 1212 when the bus capacitor 1223 is faulty.

FIG. 16 is still another diagram of the power conversion circuit and the bottom housing according to an embodiment of this application. As shown in FIG. 2 and FIG. 16, in an embodiment, the terminal panel 1210 further includes a first communication terminal 1217. The power conversion circuit 122 further includes a first communication circuit 1228, and the first communication circuit 1228 is accommodated in the third accommodation cavity 33. The first communication terminal 1217 penetrates the terminal panel 1210, and one end of the first communication terminal 1217 that extends into the third accommodation cavity 33 is electrically connected to the first communication circuit 1228. In this embodiment, the first communication terminal 1217 is configured to transmit data in parallel to an external device, and may send and receive parameter data of the photovoltaic inverter 12. For example, the first communication terminal 1217 may be communicatively connected to the external device in a wireless connection manner like 4G or FE (fast Ethernet). In this embodiment, the other end of the guide plate 332 inclines toward the first communication terminal 1217. Because the first communication circuit 1228 is a circuit with weak power, the guide plate 332 guides the electrolyte in the groove 331 toward the first communication terminal 1217, to prevent the electrolyte from entering the circuit with strong power and causing damage to the power conversion circuit 122.

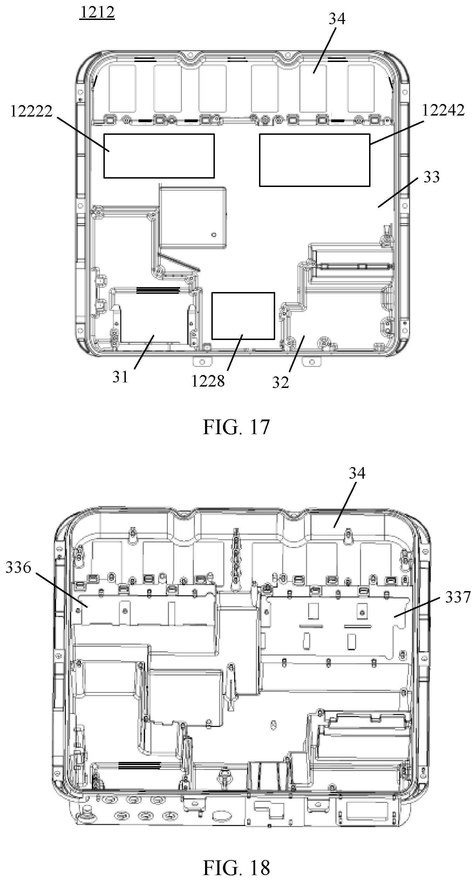

FIG. 17 is yet another diagram of the power conversion circuit and the bottom housing according to an embodiment of this application. FIG. 18 is still yet another diagram of the bottom housing according to an embodiment of this application. As shown in FIG. 17 and FIG. 18, in an embodiment, the power module includes a first switching transistor 12222 and a second switching transistor 12242. The first switching transistor 12222 is electrically connected between the direct current input terminal 1213 and the first inductor 12221, and the second switching transistor 12242 is electrically connected between the bus capacitor 1223 and the second inductor 12241. The first switching transistor 12222 and the second switching transistor 12242 are located in the third accommodation cavity 33, the first switching transistor 12222 is disposed close to the first inductor 12221, and the second switching transistor 12242 is disposed close to the second inductor 12241. The switching transistor and the inductor are separated, so that interference between the switching transistor and the inductor can be reduced, and heat dissipation areas of the direct current conversion circuit 1222 and the inverter circuit 1224 are separately increased.

In the photovoltaic inverter 12, a first insulating and thermally conductive substrate 336 and a second insulating and thermally conductive substrate 337 are disposed in the third accommodation cavity 33, a surface of the first switching transistor 12222 that faces the bottom housing 1212 is attached to the first insulating and thermally conductive substrate 336, and a surface of the second switching transistor 12242 that faces the bottom housing 1212 is attached to the second insulating and thermally conductive substrate 337. The first switching transistor 12222 is thermally connected to the bottom housing 1212 via the first insulating and thermally conductive substrate 336, and the second switching transistor 12242 is thermally connected to the bottom housing 1212 via the second insulating and thermally conductive substrate 337, so that heat dissipation efficiency of the first switching transistor 12222 and the second switching transistor 12242 can be accelerated. In addition, the first switching transistor 12222, the second switching transistor 12242, and the bus capacitor 1223 are located in a same accommodation cavity, so that the first insulating and thermally conductive substrate 336 and the second insulating and thermally conductive substrate 337 can reduce impact of the bus capacitor 1223 on the first switching transistor 12222 and the second switching transistor 12242 when the bus capacitor 1223 is faulty.

As shown in FIG. 4, in an embodiment, a second spacer plate 341 is disposed in the fourth accommodation cavity 34, and the second spacer plate 341 divides the fourth accommodation cavity 34 into a first cavity 342 and a second cavity 343. The first cavity 342 and the second cavity 343 are separately disposed adjacent to the third accommodation cavity 33. The first inductor 12221 is accommodated in the first cavity 342, and the second inductor 12241 is accommodated in the second cavity 343. In the fourth accommodation cavity 34, the second spacer plate 341 separates the first inductor 12221 from the second inductor 12241, so that interference between the first inductor and the second inductor 12241 can be reduced. In addition, the second spacer plate 341 may further increase a heat dissipation area between the first inductor 12221 and the housing 121 and a heat dissipation area between the second inductor 12241 and the housing 121, to improve heat dissipation efficiency of the first inductor 12241 and the second inductor 12241.

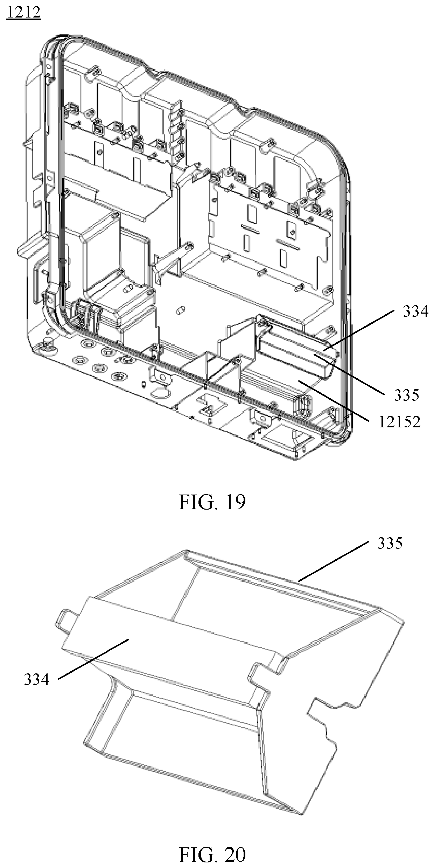

In an embodiment, the power conversion circuit 122 further includes a plurality of relays. The plurality of relays are located on a side of the circuit board 1226 that faces away from the cover body 1211. FIG. 19 is another diagram of the power conversion circuit according to an embodiment of this application. As shown in FIG. 19, the plurality of spacer plates 1215 further include a third spacer plate 12152, and the third accommodation cavity 33 and the second accommodation cavity 32 are separated by the third spacer plate 12152, that is, the third accommodation cavity 33 and the second accommodation cavity 32 are located on two sides of the third spacer plate 12152. A thermal pad 334 is disposed on a side of the third spacer plate 12152 that faces the cover body 1211, and the thermal pad 334 is configured to be in contact with the circuit board 1226. The plurality of relays are distributed in two rows on two sides of the thermal pad 334. When the photovoltaic inverter 12 operates, the relay and a region of the circuit board 1226 that is close to the relay generate heat. The thermal pad 334 may be configured to be attached to the circuit board 1226 of the power conversion circuit 122, so that the heat near the relay on the circuit board 1226 can be transferred from the thermal pad 334 to the bottom housing 1212, to reduce heat of the relay and avoid a fault caused by overheating of the relay.

In this application, a pin is disposed on a side of the relay that faces the circuit board 1226, and the pin is fastened to the circuit board 1226 and is connected to a metal trace. The plurality of relays are distributed on a periphery of the thermal pad 334, so that a distance between the region of the circuit board 1226 that is close to the relay and the thermal pad 334 can be shorter. FIG. 20 is a diagram of the thermal pad and a metal support according to an embodiment of this application. As shown in FIG. 19 and FIG. 20, in an embodiment, the metal support 335 is further disposed on the side of the third spacer plate 12152 that faces the cover body 1211. The thermal pad 334 is fastened to a side of the metal support 335 that faces the cover body 1211, and the plurality of relays are distributed in two rows on two sides of the metal support 335. Therefore, the metal support 335 may be configured to accommodate the relay, and may also transfer heat of the thermal pad 334 to the bottom housing 1212.

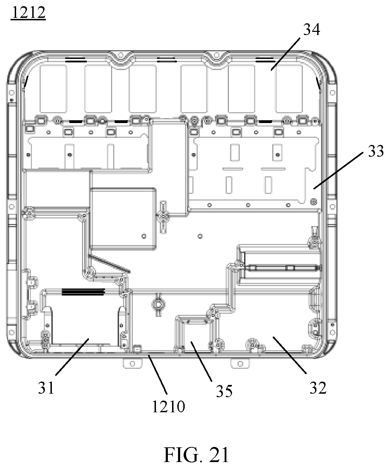

FIG. 21 is a still further diagram of the bottom housing according to an embodiment of this application. As shown in FIG. 2, FIG. 3, and FIG. 21, in an embodiment, the terminal panel 1210 further includes a second communication terminal 1218. The plurality of accommodation cavities further include a fifth accommodation cavity 35, the fifth accommodation cavity 35 is disposed adjacent to the terminal panel 1210, and the fifth accommodation cavity 35 is located between the second accommodation cavity 32 and the third accommodation cavity 33. The power conversion circuit 122 further includes a second communication circuit, and the second communication circuit is accommodated in the fifth accommodation cavity 35. The second communication terminal 1218 penetrates the terminal panel 1210, and one end of the second communication terminal 1218 that extends into the fifth accommodation cavity 35 is electrically connected to the second communication circuit. The second communication terminal 1218 is configured to transmit data serially to the external device. For example, the second communication terminal 1218 may be communicatively connected to the external device through a communication cable. In this embodiment, the second communication terminal 1218, the direct current input terminal 1213, and the alternating current output terminal 1214 are disposed on a same side, so that wiring of the photovoltaic inverter 12 can be disposed on a same side, to facilitate mounting of the photovoltaic inverter 12.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic inverter, comprising a housing, a circuit board, and a power conversion circuit, wherein the circuit board and the power conversion circuit are accommodated in the housing;
the housing comprises a bottom housing and a cover body, and the cover body is configured to cover the bottom housing; a plurality of heat dissipation fins are disposed on a surface of a side of the bottom housing that faces away from the cover body; the circuit board is disposed between the bottom housing and the cover body, and a plane on which the circuit board is located is parallel to a surface of the cover body relative to the bottom housing; and a plurality of spacer plates are disposed on the bottom housing, and the plurality of spacer plates extend from the bottom housing toward the circuit board, and divide space between the bottom housing and the circuit board into a plurality of accommodation cavities;
the plurality of accommodation cavities comprise a first accommodation cavity, a second accommodation cavity, a third accommodation cavity, and a fourth accommodation cavity; the bottom housing or the cover body comprises a terminal panel, and the terminal panel comprises a direct current input terminal and an alternating current output terminal; the first accommodation cavity, the second accommodation cavity, and the third accommodation cavity are all disposed adjacent to the terminal panel; and the third accommodation cavity is located between the first accommodation cavity and the second accommodation cavity, the fourth accommodation cavity is located on a side of the third accommodation cavity that faces away from the terminal panel, and the third accommodation cavity is located between the fourth accommodation cavity and the first accommodation cavity, or the third accommodation cavity is located between the fourth accommodation cavity and the second accommodation cavity;
the power conversion circuit comprises a first inductor, a bus capacitor, and a second inductor that are sequentially connected in series, the bus capacitor is located in the third accommodation cavity, and the first inductor and the second inductor are located in the fourth accommodation cavity; the direct current input terminal penetrates the terminal panel, one end of the direct current input terminal that extends into the first accommodation cavity is electrically connected to the first inductor, and the other end of the direct current input terminal is configured to electrically connect to a photovoltaic module; and the alternating current output terminal penetrates the terminal panel, one end of the alternating current output terminal that extends into the second accommodation cavity is electrically connected to the second inductor, and the other end of the alternating current output terminal is configured to electrically connect to a power grid or a load; and
the power conversion circuit further comprises a power module, the power module is located in the third accommodation cavity, and an insulating and thermally conductive substrate is disposed between the power module and a bottom wall of the third accommodation cavity.

2. The photovoltaic inverter according to claim 1, wherein in the third accommodation cavity, a groove is disposed on a surface of a side of the bottom housing that faces the cover body, and the bus capacitor is partially accommodated in the groove.

3. The photovoltaic inverter according to claim 2, wherein an insulating film is disposed in the groove, an explosion-relief valve is disposed on a surface of a side of the bus capacitor that faces the insulating film, and the explosion-relief valve is spaced from the insulating film by a predetermined distance.

4. The photovoltaic inverter according to any one of claims 1 to 3, wherein the plurality of spacer plates comprise a first spacer plate, and the first accommodation cavity and the third accommodation cavity are separated by the first spacer plate; and
in the third accommodation cavity, a guide plate is disposed on the side of the bottom housing that faces the cover body, and a plane on which the guide plate is located is perpendicular to the surface of the cover body relative to the bottom housing; and the guide plate is located between the groove and the terminal panel, one end of the guide plate is connected to the first spacer plate, and the other end of the guide plate inclines toward the terminal panel.

5. The photovoltaic inverter according to claim 4, wherein the power conversion circuit further comprises a first communication circuit, the first communication circuit is accommodated in the third accommodation cavity, and the first communication circuit is disposed close to the terminal panel; the terminal panel further comprises a first communication terminal; the first communication terminal penetrates the terminal panel, and one end of the first communication terminal that extends into the third accommodation cavity is electrically connected to the first communication circuit; and the first communication terminal is configured to transmit data in parallel to an external device, and the other end of the guide plate inclines toward the first communication terminal.

6. The photovoltaic inverter according to any one of claims 1 to 5, wherein the plurality of spacer plates comprise a second spacer plate, and the second spacer plate divides the fourth accommodation cavity into a first cavity and a second cavity; the first cavity and the second cavity are separately disposed adjacent to the third accommodation cavity; and the first inductor is accommodated in the first cavity, and the second inductor is accommodated in the second cavity.

7. The photovoltaic inverter according to claim 6, wherein the power module comprises a first switching transistor and a second switching transistor; the first switching transistor is electrically connected between the direct current input terminal and the first inductor, and the second switching transistor is electrically connected between the bus capacitor and the second inductor; and the first switching transistor is disposed close to the first inductor, and the second switching transistor is disposed close to the second inductor.

8. The photovoltaic inverter according to any one of claims 1 to 7, wherein the power conversion circuit further comprises a plurality of relays, and the plurality of relays are located between the circuit board and the bottom housing; and
the plurality of spacer plates comprise a third spacer plate, and the second accommodation cavity and the third accommodation cavity are separated by the third spacer plate; a thermal pad is disposed at an end of the third spacer plate that faces the cover body, and the thermal pad is configured to be in contact with the circuit board; and the plurality of relays are distributed in two rows on two sides of the thermal pad.

9. The photovoltaic inverter according to claim 8, wherein a metal support is further disposed at the end of the third spacer plate that faces the cover body, the thermal pad is fastened to an end of the metal support that faces the cover body, and the plurality of relays are distributed in two rows on two sides of the metal support.

10. The photovoltaic inverter according to any one of claims 1 to 9, wherein the plurality of accommodation cavities further comprise a fifth accommodation cavity, the fifth accommodation cavity is disposed adjacent to the terminal panel, and the fifth accommodation cavity is located between the third accommodation cavity and the second accommodation cavity;
the power conversion circuit further comprises a second communication circuit, and the second communication circuit is accommodated in the fifth accommodation cavity; and
the terminal panel further comprises a second communication terminal, the second communication terminal penetrates the terminal panel, one end of the second communication terminal that extends into the fifth accommodation cavity is electrically connected to the second communication circuit, and the second communication terminal is configured to transmit data serially to the external device.

11. The photovoltaic inverter according to any one of claims 1 to 10, wherein the photovoltaic inverter further comprises a switch, the switch is disposed in the housing, the switch is connected between the direct current input terminal and the first inductor, and the switch is configured to conduct or disconnect an electrical connection between the photovoltaic module and the power conversion circuit.

12. The photovoltaic inverter according to any one of claims 1 to 11, wherein a chip resistor, a chip capacitor, and a signal indicator are disposed on a side of the circuit board that faces the cover body, and the signal indicator is configured to indicate an operating status of the photovoltaic inverter.
